# EUROPEAN PATENT SPECIFICATION

(11) **EP 1 560 280 B1**
(45) Date of publication and mention of the grant of the patent: **12.12.2007**
(21) Application number: 03810583.9
(22) Date of filing: 22.10.2003
(51) Int. Cl.: H01L 41/18, H01L 41/22

(54) **THIN FILM MULTILAYER BODY, ELECTRONIC DEVICE USING SUCH THIN FILM MULTILAYER BODY, ACTUATOR, AND METHOD FOR MANUFACTURING ACTUATOR**
MEHRSCHICHTIGER DÜNNFILMKÖRPER, EINEN SOLCHEN MEHRSCHICHTIGEN DÜNNFILMKÖRPER BENUTZENDE ELEKTRONISCHE EINRICHTUNG, BETÄTIGUNGSGLIED UND VERFAHREN ZUR HERSTELLUNG DES BETÄTIGUNGSGLIEDS
CORPS MULTICOUCHE A FILM MINCE, DISPOSITIF ELECTRONIQUE UTILISANT UN TEL CORPS, UNITE DE COMMANDE ET PROCEDE DE FABRICATION DE CELLE-CI

(30) Priority: 07.11.2002 JP 2002324363
(43) Date of publication of application: 03.08.2005
(73) Proprietor: FUJITSU LIMITED, Kawasaki-shi, Kanagawa 211-8588 (JP)
(72) Inventor: KONDO, Masao, c/o FUJITSU LIMITED, Kawasaki-shi, Kanagawa 211-8588 (JP); YAMAWAKI, Hideki, c/o FUJITSU LIMITED, Kawasaki-shi, Kanagawa 211-8588 (JP)
(74) Representative: Wiedemann, Peter
(86) International application number: PCT/JP2003/013500
(87) International publication number: WO 2004/042836

(56) References cited:
- EP-A- 1 229 569
- JP-A- 11 207 957
- JP-A- 63 055 198
- US-A- 5 084 438
- US-A- 5 776 621
- US-A- 6 151 240
- PATENT ABSTRACTS OF JAPAN vol. 007, no. 076 (E-167), 30 March 1983 (1983-03-30) & JP 58 006147 A (NIPPON DENKI KK), 13 January 1983 (1983-01-13)
- PATENT ABSTRACTS OF JAPAN vol. 015, no. 236 (E-1078), 18 June 1991 (1991-06-18) & JP 03 071656 A (SANYO ELECTRIC CO LTD), 27 March 1991 (1991-03-27)

## Description

### TECHNICAL FIELD

The present invention relates to a thin film multilayer body in which an oxide layer that has a crystalline structure having a simple perovskite lattice in the crystal and shows a high dielectric property, a piezoelectric property, a dielectric property, a pyroelectric property, etc., can be grown epitaxially; a thin film multilayer body in which such an oxide layer is formed; and an electronic device having the thin film multilayer body in which such an oxide layer is formed. The electronic device is suitable for, for instance, an actuator for precise positioning, the driving part of a buzzer, etc., a capacitor element, a DRAM, an FeRAM, and a SAW device.

### BACKGROUND ART

In recent years, small-size, high-performance actuators employable in various drive units such as the head positioning mechanism of a magnetic disk unit and the driving mechanism of a micromachine for medical use have been longed for. As such actuators that need to be reduced in size, those using a piezoelectric material or an electrostrictive material that mechanically deforms on application of an electric field are suitable because they can be mounted as thin films.

Of piezoelectric and electrostrictive materials, those showing a practically sufficient piezoelectric or electrostrictive property are limited to some oxides. Of the oxides, for instance, most of substances having a perovskite structure having a simple perovskite lattice in the crystal, a bismuth layer structure, a tungsten bronze structure, etc., are ferroelectrics, and are appealing materials having a piezoelectric property, a dielectric property, a pyroelectric property, semiconductivity, and electric conductivity. In particular, materials that have perovskite structures and show good properties are limited to oxides.

A piezoelectric property or an electrostrictive property results from the arrangement of atoms constituting an oxide. Therefore, it is necessary to be a crystal. A single crystal film that has uniform composition and no defects is ideal in order to obtain more ideal properties. In general, however, it is not easy to obtain a single crystal film. Piezoelectric materials and the like commonly used are polycrystalline films, which include a large number of defects of grain boundaries, etc., so that the properties are degraded compared with a single crystal film. Accordingly, since the properties tend to improve by the orientation in a particular plane direction, a so-called epitaxial film, a film oriented not only in a stacking direction but also in an in-film plane direction, is preferable.

Conventionally, oxide single crystal substrates of magnesium oxide (MgO), strontium titanate (SrTiO₃), lanthanum aluminate (LaAlO₃), etc., have been employed to grow an oxide epitaxial film. A platinum film whose principal plane is the (001) surface is grown on these oxide single crystal substrates as a lower electrode, and an oxide crystalline film is further epitaxially grown and formed on the platinum film.

However, commonly used oxide single crystal substrates are approximately 2 in., and are difficult to increase in size. Further, in terms of price, while 6 in. silicon single crystal substrates cost several thousand yen, 2 in. MgO substrates are expensive and cost more than one hundred thousand yen, thus being difficult to put to practical use. Accordingly, it has been studied to employ a silicon single crystal substrate as a substrate for growing the epitaxial film of an oxide layer.

First, in order to grow an epitaxial film on a silicon single crystal substrate, it is necessary to use the orientation of the surface of the silicon single crystal substrate. However, when the surface of the silicon single crystal substrate is exposed in an oxygen atmosphere at high temperatures, it is oxidized so that a silicon oxide film (SiOₓ) is formed. The silicon oxide film is amorphous and has no orientation. Therefore, no epitaxial film grows on the silicon oxide film. Further, it is also important for the growth of the epitaxial film that the reaction or diffusion between the film to be grown and the silicon single crystal substrate be reduced. Accordingly, as materials that can be epitaxially grown on the silicon single crystal substrate, rare earth element oxides such as yttrium stabilized zirconia (YSZ) and cerium oxide (CeO₂), magnesium oxide (MgO), magnesia spinel (MgAl₂O₄), and strontium titanate (SrTiO₃) have been disclosed so far. Attempts have been made to form an epitaxial film of an oxide having a perovskite structure on an intermediate layer using crystal layers of these materials as the intermediate layers.

Of these intermediate layers, a magnesia spinel film is known to grow epitaxially on a silicon substrate (001) surface with its (001) surface serving as a principal plane and is further known to have the perovskite structure (001) surface grow epitaxially (for instance, see Non-Patent Document 1).

By the way, for use for actuators and capacitor elements, a conductive layer serving as a lower electrode is required between the intermediate layer and the oxide layer. That is, it is necessary to provide a conductive layer between the magnesia spinel layer and the epitaxial film of the perovskite oxide layer.

However, in the case of providing a conductive layer, if the conductive layer has low crystallinity or is not epitaxially grown on the magnesia spinel film, crystallinity is reduced or the crystal orientation of the perovskite oxide layer formed on the conductive layer is changed so as to deviate greatly from a polarization direction, thus causing a problem in that the piezoelectric property or the electrostrictive property is reduced.

Patent Document 1 Japanese Laid-Open Patent Application No. 55-61035;

Non-Patent Document 1 Matsubara et al; J. Appl. Phys., 66 (1989) 5826. US-A-5 776 621 discloses a multi layer body according to the preamble of claims 1 and 3.

### DISCLOSURE OF THE INVENTION

Accordingly, it is a general object of the present invention to provide a novel and useful thin film multilayer body, an electronic device and actuator using the thin film multilayer body, and a method of manufacturing the actuator in which the above-described problem is solved.

A first object of the present invention is to realize a thin film multilayer body that has a conductive layer and in which an oxide layer having good crystallinity and showing a high dielectric property and a good piezoelectric or electrostrictive property is formable.

A second object of the present invention is to realize a high-performance electronic device and actuator that have an oxide layer having good crystallinity and showing a good piezoelectric or electrostrictive property and can be higher in performance and lower in cost.

A third object of the present invention is to realize a method of manufacturing an actuator that has the above-described thin film multilayer body and can be higher in performance and lower in cost.

According to one aspect of the present invention, a thin film multilayer body is provided that includes a single crystal substrate of silicon or gallium arsenide; an intermediate layer of magnesia spinel formed on the single crystal substrate by epitaxial growth; and a conductive layer of iridium formed on the intermediate layer by epitaxial growth, wherein an oxide layer is to be epitaxially grown on the conductive layer, the oxide layer having a crystalline structure having a simple perovskite lattice.

According to the present invention, the conductive layer of iridium is epitaxially grown and formed on the magnesia spinel intermediate layer. Accordingly, since the conductive layer of iridium has good crystallinity, it is possible to have an oxide layer of a crystalline structure having a simple perovskite lattice grown epitaxially on the conductive layer. Further, since the silicon or gallium arsenide single crystal substrate is employed for the thin film multilayer body, it is possible to increase area and reduce cost compared with the case of employing the conventional MgO single crystal substrate.

According to another aspect of the present invention, a thin film multilayer body is provided that includes a single crystal substrate of silicon or gallium arsenide; an intermediate layer of magnesia spinel formed on the single crystal substrate by epitaxial growth; a conductive layer of iridium formed on the intermediate layer by epitaxial growth; and an oxide layer formed on the conductive layer by epitaxial growth, the oxide layer having a crystalline structure having a simple perovskite lattice.

According to the present invention, the oxide layer is epitaxially grown on the conductive layer with the (001) surface being a growth direction. Accordingly, the oxide layer has good crystallinity, and is excellent in polarization, dielectric constant, piezoelectric property, and electrostrictive property since it is possible to match a voltage application direction with the polarization axis.

An amorphous layer may be additionally formed between the single crystal substrate and the intermediate layer. The intermediate layer is formed by epitaxial growth on the single crystal substrate. Accordingly, the surface of the single crystal substrate and a magnesia spinel film that is the intermediate layer grown thereon form a heteroepitaxial structure, and they are firmly joined at their interface. As a result, even when heat treatment, etc., causes the atoms constituting the magnesia spinel film to attempt rearrangement, the atoms are bound by the atomic arrangement of the crystal face of the single crystal substrate so that their rearrangement is restricted. By cutting the binding by providing an amorphous layer at the interface of the magnesia spinel film and the single crystal substrate with the magnesia spinel film being formed on the single crystal substrate, it is possible for the magnesia spinel film to perform rearrangement. Accordingly, the magnesia spinel film has better crystallinity, and the conductive layer and the oxide layer formed thereon inherit the good crystallinity of the magnesia spinel film so that each layer has better crystallinity.

According to another aspect of the present invention, an electronic device having either one of the above-described thin film multilayer bodies is provided.

According to the present invention, in the thin film multilayer bodies, the oxide layer of a crystalline structure having a simple perovskite lattice on the conductive layer has good crystallinity. Further, since the silicon or gallium arsenide single crystal substrate is employed, it is possible to increase area and reduce cost compared with the case of employing the conventional MgO single crystal substrate. Accordingly, it is possible to realize a low-price electronic device having an oxide layer that shows a high dielectric property and a good piezoelectric or electrostrictive property.

According to another aspect of the present invention, an actuator is provided that includes a single crystal substrate of silicon or gallium arsenide; an intermediate layer of magnesia spinel formed on the single crystal substrate by epitaxial growth; a lower conductive layer of iridium formed on the intermediate layer by epitaxial growth; an oxide layer formed on the lower conductive layer by epitaxial growth, the oxide layer having a crystalline structure having a simple perovskite lattice; and an upper conductive layer formed on the oxide layer, the oxide layer showing a piezoelectric or electrostrictive property.

According to the present invention, the oxide layer of a crystalline structure having a simple perovskite lattice is formed with the (001) surface grown epitaxially. Accordingly, the oxide layer has good crystallinity, and shows a good dielectric constant, piezoelectric property, and electrostrictive property since it is possible to match a voltage application direction with the polarization axis of the oxide layer by applying voltage between the lower conductive layer and the upper conductive layer. Further, since the silicon or gallium arsenide single crystal substrate is employed, it is possible to increase area and reduce cost compared with the case of employing the conventional MgO single crystal substrate.

An amorphous layer may be additionally formed between the single crystal substrate and the intermediate layer. An opening part may be provided to the amorphous layer. Film thickness is reduced by providing only the intermediate layer and the lower conductive layer on one side of the oxide layer so as to provide more flexibility. Further, a space for deflection at the time of the displacement of the oxide layer is provided so as to allow the actuator to be displaced in a wider range. As a result, the displacement efficiency of the actuator can be further improved.

A recess may be provided on the bottom side of the single crystal substrate. By providing flexibility by reducing the single crystal substrate in film thickness, the displacement efficiency of the actuator can be further improved.

The crystalline structure having the perovskite lattice may be one of a perovskite structure, a bismuth layer structure, and a tungsten bronze structure. The oxide layer having such a crystalline structure has a good piezoelectric or electrostrictive property. Since the oxide layer has good crystallinity, the displacement efficiency of the actuator can be improved.

According to another aspect of the present invention, a method of manufacturing an actuator in which epitaxial films are stacked is provided that includes an intermediate layer formation process of forming an intermediate layer of magnesia spinel on a single crystal substrate of silicon or gallium arsenide by epitaxial growth; a lower conductive layer formation process of forming a lower conductive layer of iridium on the intermediate layer by epitaxial growth; an oxide layer formation process of forming an oxide layer of a crystalline structure having a simple perovskite lattice on the lower conductive layer by epitaxial growth; and an upper conductive layer formation process of forming an upper conductive layer on the oxide layer.

According to the present invention, the oxide layer of a crystalline structure having a simple perovskite lattice is epitaxially grown and formed. Accordingly, the oxide layer has good crystallinity, and therefore, shows a good piezoelectric or electrostrictive property. Further, since the silicon or gallium arsenide single crystal substrate is employed, it is possible to increase area and reduce cost compared with the case of employing the conventional MgO single crystal substrate.

The process of forming an amorphous layer between the single crystal substrate and the intermediate layer by heat treatment may be provided between the intermediate layer formation process and the conductive layer formation process. This heat treatment causes oxygen from the magnesia spinel intermediate layer to diffuse into the single crystal substrate, so that an amorphous layer due to thermal oxidation is formed on the surface of the single crystal substrate. Accordingly, the single crystal substrate and the magnesia spinel are unbound by the amorphous layer. As a result, the rearrangement of the atoms constituting the magnesia spinel occurs, so that it is possible to further improve the crystallinity of the magnesia spinel intermediate layer.

### BRIEF DESCRIPTION OF THE DRAWINGS

FIG. 1 is a sectional view of an actuator according to a first mode of implementation of the present invention;
FIG. 2 is a flowchart showing a manufacturing process of the actuator according to the first mode of implementation;
FIG. 3 is a diagram showing an X-ray diffraction pattern of a thin film multilayer body that is an important part of the first mode of implementation, the thin film multilayer body being formed of a single crystal substrate/an intermediate layer/a lower conductive layer;
FIGS. 4A through 4C are diagrams showing X-ray diffraction patterns of the respective films of the thin film multilayer body by φ scan;
FIG. 5A is a diagram showing a rocking curve with respect to a (002) surface of the platinum film of the thin film multilayer body;
FIG. 5B is a diagram showing a rocking curve with respect to a (002) surface of a platinum film epitaxially grown on a MgO single crystal substrate that is not according to the present invention;
FIG. 6 is a diagram showing an X-ray diffraction pattern of a PLZT film according to the first mode of implementation by φ scan;
FIG. 7 is a sectional view of an actuator according to a second mode of implementation of the present invention;
FIG. 8 is a sectional view of an actuator according to a third mode of implementation of the present invention;
FIG. 9A is a sectional view of an actuator according to a fourth mode of implementation of the present invention;
FIG. 9B is a view on arrow X-X shown in FIG. 9A; and
FIGS. 10A through 10C are diagram showing a manufacturing process of the actuator according to the fourth mode of implementation.

Description of numerals: 10, 20, 30, 40 ... actuator; 11, 21, 31, 41 ... single crystal substrate; 12 ... intermediate layer; 13 ... lower conductive layer; 14 ... oxide layer; 15 ... upper conductive layer; 16 ... thin film multilayer body formed of a single crystal substrate/the intermediate layer 12/the lower conductive layer 13; 22, 42 ... amorphous layer; 31-1 ... recess of the single crystal substrate; 41-1 ... groove; 42-1, 43-1 ... opening part; 43 ... resist; and 44 ... protection film.

### BEST MODE FOR CARRYING OUT THE INVENTION

A description is given below, based on the drawings, of modes of implementation of the present invention.

### (First Mode of Implementation)

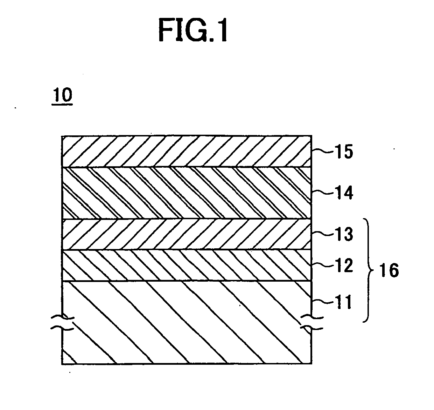

FIG. 1 is a sectional view of an actuator according to a mode of implementation of the present invention.

Referring to FIG. 1, an actuator 10 of this mode of implementation is formed by sequentially stacking an intermediate layer 12, a lower conductive layer 13, an oxide layer 14, and an upper conductive layer 15 on a single crystal substrate 11. On application of voltage between the lower conductive layer 13 and the upper conductive layer 15, the actuator 10, for instance, stretches longitudinally because of the longitudinal effect of the oxide layer 14 using the piezoelectric or electrostrictive property of the oxide layer 14.

As the single crystal substrate 11, a single crystal substrate of, for instance, silicon or gallium arsenide (GaAs) is employed. The single crystal substrate 11 is approximately 500 µm in thickness, and its principal plane is the (001) surface. By letting the (001) surface be the principal plane, the layers to be epitaxially grown on the single crystal substrate 11 may have the same surface orientation, so that finally, the surface orientation of the oxide layer 14 can be the (001) surface. The single crystal substrate 11 whose principal plane is the (001) surface and is slightly inclined within the range of 0° to 4° may also be employed. Grain boundaries may be generated in the intermediate layer 12 because of the minute unevenness of the surface of the single crystal substrate 11. By using the slightly inclined single crystal substrate 11, growth directions in the film plane of the intermediate layer 12 can be equalized so that the generation of grain boundaries can be controlled.

The intermediate layer 12 is formed of 100 nm thick magnesia spinel (MgAl₂O₄) grown epitaxially on the single crystal substrate 11 by CVD, etc. Specifically, the intermediate layer 12 is 80 nm to 600 nm in thickness. The magnesia spinel film, which is the intermediate layer 12, has its (001) surface grown on the (001) surface of a silicon single crystal substrate, for instance. The (001) surface of the magnesia spinel film is formed on the (001) surface of the single crystal substrate 11, so that the [100] direction of the single crystal substrate 11 matches the [100] direction of the magnesia spinel film.

The lower conductive layer 13 is formed of iridium according to the invention. In the following alternative arrangements not according to the invention but useful in the understanding thereof are also described. The conductive layer of iridium of 200 nm in thickness is grown epitaxially on the intermediate layer 12 by RF sputtering, etc. A platinum-group element is, for instance, Ru, Rh, Pd, Os, Ir, or Pt. Of these, Ir or Pt is suitable in particular in that good crystal orientation can be obtained.

Further, the lower conductive layer 13 is the (001) surface of the platinum-group element or its alloy grown on the (001) surface of the magnesia spinel. Conventionally, reports have been made of the case where a magnesia spinel epitaxial film and further a PZT film, etc., are formed on a silicon single crystal substrate. However, there has been no report of the case where a magnesia spinel film and an epitaxial film of a platinum-group element or its alloy are sequentially stacked on a silicon single crystal substrate. A thin film multilayer body 16 formed of the single crystal substrate 11/the magnesia spinel intermediate layer 12/the lower electrode layer 13 of a film of a platinum-group element or its alloy according to this mode of implementation is extremely useful in that the below-described oxide layer 14 of a crystalline structure having a simple perovskite lattice can be grown on this thin film multilayer body 16 and that the piezoelectric or electrostrictive property and a high dielectric constant of the oxide layer can be utilized by employing the lower conductive layer 13 of a platinum-group element or its alloy, which is conductive, as an electrode.

The oxide layer 14 is formed of a crystal having a simple perovskite lattice whose (001) surface is epitaxially grown on the (001) surface of the lower conductive layer 13. A perovskite structure, a bismuth layer structure, a tungsten bronze structure and the like can be taken as examples of crystals having a simple perovskite lattice. Most of the crystals having these crystalline structures are ferroelectrics and have a piezoelectric or electrostrictive property, a pyroelectric property, etc. Some of the crystals have semiconductivity or electric conductivity.

The oxide layer 14 has a perovskite structure. For instance, PZT expressed by the general formula Pb(Zr₁₋ₓTiₓ)O₃ (0 ≤ x ≤ 1) may be used. Further, crystals expressed by the general formula Pb(B'_{1/3}B''_{2/3})O₃ (B': bivalent metal, B'': pentavalent metal), Pb (B'_{1/2}B''_{1/2})O₃ (B': trivalent metal, B'': pentavalent metal), or Pb(B'_{1/2}B''_{1/2})O₃ (B': bivalent metal, B'': hexavalent metal), PLZT expressed by the general formula (Pb_{1-y}La_{y}) (Zr₁₋ₓTiₓ)O₃ (0 ≤ x, y ≤ 1) by further adding an additional element to PZT, and crystals expressed by the general formula Pb(B'_{1/3}B''_{2/3})ₓTi_{y}Zr_{1-x-y}O₃ (0 ≤ x, y ≤ 1, B': bivalent metal, B'': pentavalent metal), Pb(B'_{1/2}B"_{1/2})ₓTi_{y}Zr_{1-x-y}O₃ (0 ≤ x, y ≤ 1, B': trivalent metal, B'': pentavalent metal), or Pb(B'_{1/2}B''_{1/2})ₓTi_{y}Zr_{1-x-y}O₃ (0 ≤ x, y ≤ 1, B': bivalent metal, B'': hexavalent metal) may be used. They are suitable because a higher piezoelectric or electrostrictive property than PZT can be obtained.

Of the crystals expressed by the above-described general formula Pb(B'_{1/3}B''_{2/3})O₃ (B': bivalent metal, B'': pentavalent metal), PbNi_{1/3}Nb_{2/3}O₃, PbCo_{1/3}Nb_{2/3}O₃, PbMg_{1/3}Nb_{2/3}O₃, PbZn_{1/3}Nb_{2/3}O₃, PbMn_{1/3}Nb_{2/3}O₃, PbNi_{1/3}Ta_{2/3}O₃, PbCo_{1/3}Ta_{2/3}O₃, PbMg_{1/3}Ta_{2/3}O₃, PbZn_{1/3}Ta_{2/3}O₃, and PbMn_{1/3}Ta_{2/3}O₃ are taken as examples of those preferable. Of those, PbNi_{1/3}Nb_{2/3}O₃, PbCo_{1/3}Nb_{2/3}O₃, PbMg_{1/3}Nb_{2/3}O₃, and PbZn_{1/3}Nb_{2/3}O₃ are particularly preferable.

Of the crystals expressed by the above-described general formula Pb(B'_{1/2}B''_{1/2})O₃ (B': trivalent metal, B'': pentavalent metal), PbFe_{1/2}Nb_{1/2}O₃, PbSc_{1/2}Nb_{1/2}O₃, and PbSc_{1/2}Ta_{1/2}O₃ are taken as examples of those particularly preferable.

Further, of the crystals expressed by the general formula Pb(B'_{1/2}B''_{1/2})O₃ (B': bivalent metal, B'': hexavalent metal), PbMg_{1/2}W_{1/2}O₃ is taken as an example of those preferable. Multicomponent crystals such as 0.65PbMg_{1/3}Nb_{2/3}O₃-0.35PbTiO₃ and 0.5PbNi_{1/3}Nb_{2/3}O₃-0.35PbTiO₃-0.15PbZrO₃ may also be employed.

The oxide layer 14 may be formed using CVD, CSD (Chemical Solution Deposition), sol-gel processing, PLD (Pulse Laser Deposition), or the like. There is no restriction on methods if they are applicable to a large-area substrate. CSD is suitable because it facilitates the formation on a relatively large-area substrate.

The upper conductive layer 15 is formed of metal, alloy, or a conductive oxide on the oxide layer 14. Metals or alloys suitable for the upper conductive layer 15 are those hard to oxidize, for instance, platinum-group elements and Ti. The conductive oxide is, for instance, IrO₂, RuO₂, or the like. The upper conductive layer 15 does not need to be grown epitaxially but may be formed by sputtering or vapor deposition on the oxide layer 14.

A semiconductive oxide layer or a conductive oxide layer of a crystalline structure having a perovskite lattice showing semiconductivity or conductivity may be formed between the lower conductive layer 13 and the oxide layer 14 and/or between the oxide layer 14 and the upper conductive layer 15. Specifically, as the semiconductive oxide, Nb- or La-doped SrTiO₃ is suitable, for instance. The amount of doping is, for instance, 1 at.%. Further, the conductive oxide may be SrRuO₃, CaRuO₃, LaNiO₃, LaₓSr₁₋ₓCoO₃ (0 ≤ x ≤ 1), or LaₓSr₁₋ₓMnO₃ (0 ≤ x ≤ 1). When the polarization reversal of the oxide layer 14 is repeated by applying AC voltage or the like between the lower conductive layer 13 and the upper conductive layer 15, a lattice defect such as oxygen deficiency at the interface between each of the lower conductive layer 13 and the upper conductive layer and the oxide layer 14 may cause the degradation of the spontaneous polarization of the oxide layer 14. The formation of a semiconductive or electrically conductive oxide layer between each of the lower conductive layer 13 and the upper conductive layer 15 and the oxide layer 14 makes it possible to control the degradation of the spontaneous polarization and ensure the good piezoelectric or electrostrictive property of the oxide layer for a longer period of time.

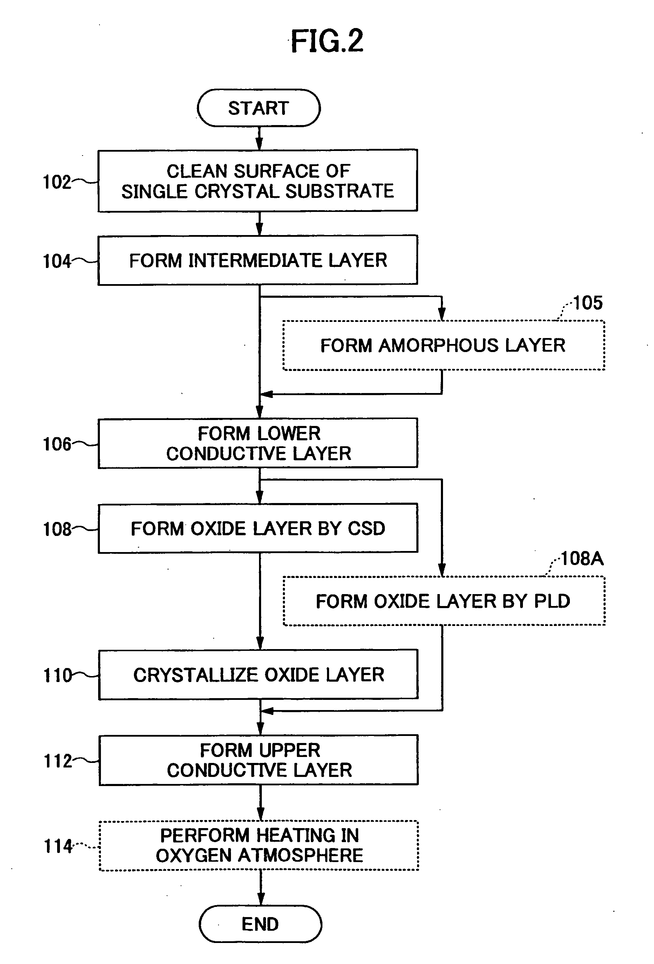

Next, a description is given of a method of manufacturing an actuator according to this mode of implementation. FIG. 2 is a flowchart showing an actuator manufacturing process according to this mode of implementation.

Referring to FIG. 2, first, after cleaning the single crystal substrate 11, the natural oxide film of the single crystal substrate 11 is removed with a dilute hydrofluoric acid. The natural oxide film is removed so that the crystal face of the single crystal substrate 11 is exposed (S102).

Next, the magnesia spinel intermediate layer 12 is epitaxially grown by CVD, MBE, or the like on the single crystal substrate 11, from which the natural oxide film has been removed (S104). CVD is suitable because it enables uniform film formation on the single crystal substrate 11 of large area, for instance, approximately 300 mm in diameter as well. In the case of using CVD, the constituent elements of magnesia spinel are heated to be vaporized in their respective source chambers, and are sent into a film formation chamber by carrier gases. The single crystal substrate 11 is heated to 750 °C to 1050 °C, and a film of 80 nm to 600 nm in thickness is formed with the film formation speed being set to from 5 nm/min. to 30 nm/min.

Next, the lower conductive layer 13 is epitaxially grown on the magnesia spinel intermediate layer 12 (S106). Specifically, the substrate is heated to and maintained at a temperature of 400 °C or over, preferably 500 °C or over, and platinum-group metal is deposited to be 20 to 2000 nm in thickness by RF sputtering in an argon gas atmosphere (S106). At this point, by adding a small amount of oxygen to the argon gas atmosphere, for instance, 1 sccm to 3 sccm of oxygen gas to 30 sccm of argon gas, the lower conductive layer 13 of better crystallinity can be formed. This is because the oxygen atoms of magnesia spinel of the surface of the intermediate layer 12 are prevented from being removed during film formation so that the crystallinity of the surface of the magnesia spinel film is maintained so as to reflect good crystallinity in the lower conductive layer 13.

Next, the oxide layer 14 is formed on the lower conductive layer 13 by, for instance, CSD (S108). Specifically, a PZT thin film formation agent in which the contents of Pb, Zr, and Ti are prepared is spin-coated onto the lower conductive layer 13, and the solvent is volatilized and dried. The spin-coating is repeated several times as required so as to have a desired thickness.

Next, heating for causing the oxide layer 14 to crystallize and grow epitaxially is performed (S110). Specifically, it is performed at 500 °C to 800 °C for 5 min. to 15 min. in an oxygen atmosphere with a halogen lamp annealing device, a furnace, or the like that enables RTA (short-time annealing).

The oxide layer 14 may be formed by PLD (S108A). Specifically, the substrate formed up to a target composed of PZT, etc., and the lower conductive layer 13 is set with the pressure inside a vacuum chamber being set to 26.6 Pa (200 mTorr), and a laser is directed to the target so that the target is atomized to be deposited on the lower conductive layer 13 via a plume. The deposition thickness is controlled by the output or repetition frequency of the laser, etc. In the case of forming a film on a large-area substrate, an oxide layer whose thickness is closer to uniformity can be formed by moving the target or moving the substrate relative to the plume.

Next, the upper conductive layer 15 is formed on the oxide layer 14 by sputtering or the like (S112). The upper conductive layer 15 does not need to be grown epitaxially, and is formed of a platinum-group element or the like as material so as to have a thickness of approximately 150 nm. The upper conductive layer 15 may be formed into a desired shape by sputtering using a mask as required.

After the upper conductive layer 15 is formed, heating may be performed in an oxygen atmosphere (S114). The surface of the oxide layer 14 is damaged by sputtered atoms forming the upper conductive layer 15 when the upper conductive layer 15 is formed. Therefore, the heating eliminates distortion and relaxes residual stress, etc., so that the crystallinity of the surface of the oxide layer 14 can be improved. Specifically, the substrate formed up to the upper conductive layer 15 is heated with a furnace or the like at a temperature of 600 °C for approximately 1 hour while letting approximately 5 sccm of oxygen flowing. As a result, the actuator 10 shown in FIG. 1 is formed.

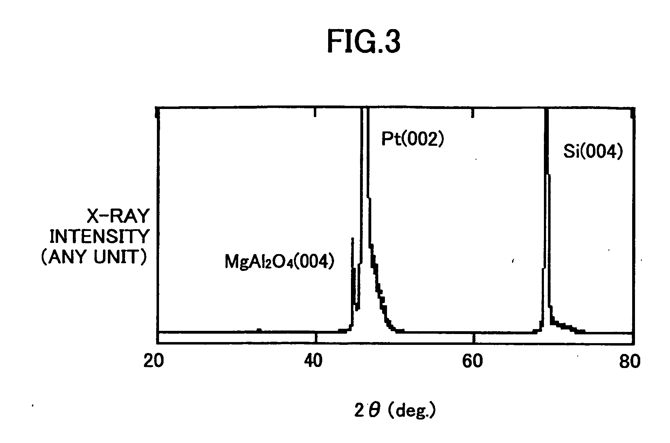

FIG. 3 is a diagram showing an X-ray diffraction pattern of the thin film multilayer body 16 by XRD, the thin film multilayer body being an important part of the actuator of this mode of implementation, being formed of the single crystal substrate 11/the intermediate layer 12/the lower conductive layer 13. Silicon, a magnesia spinel film, and a platinum film are employed as the single crystal substrate 11, the intermediate layer 12, and the lower conductive layer 13, respectively, of the thin film multilayer body 16 in the above-described mode of implementation. FIG. 3 shows measurements of intensity appearing at an angle of diffraction in a 2θ direction using an X-ray diffractometer when an X-ray is made incident on the film surface of the thin film multilayer body 16 at a formed angle θ (2θ - θ method).

Referring to FIG. 3, there appear the diffraction peaks of the (004) surface of the silicon, the (004) surface of the magnesia spinel film, and the (002) surface of the platinum film. Focusing on the diffraction peak of the platinum film, the diffraction peak of the (002) surface appears at 2θ = 46° while, for instance, the diffraction peaks of the (111) surface (2θ = 39°) and the (011) surface (2θ = 65°) do not appear. This shows that the stacking direction of the platinum film is oriented entirely in the [001] direction with the (001) surface being a principal plane. With respect to the magnesia spinel film, only the diffraction peak of the (004) surface appears. Accordingly, it is understood that the magnesia spinel film is on the (001) surface of the silicon single crystal substrate and the platinum film is on the magnesia spinel film with single-axis orientation.

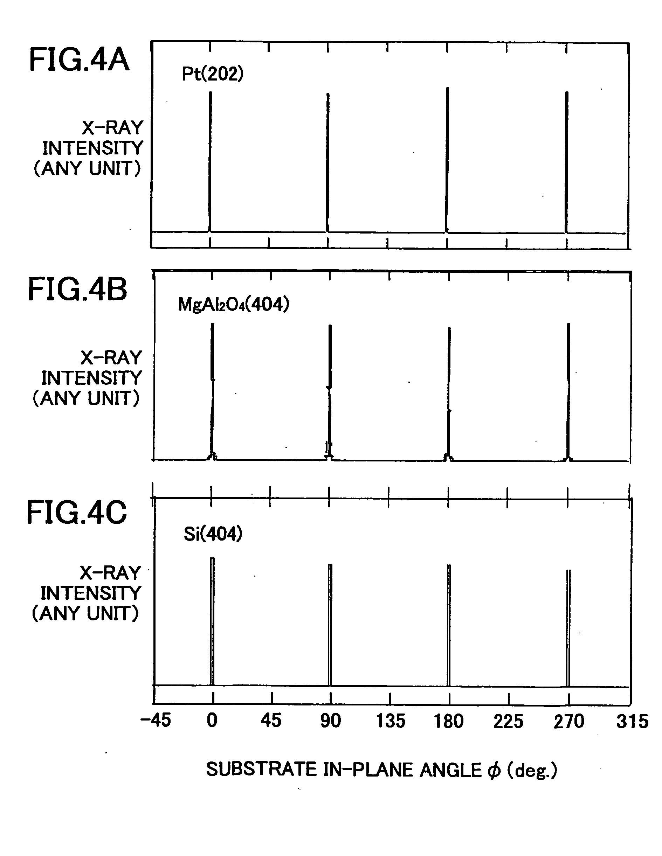

FIGS. 4A through 4C are diagrams showing X-ray diffraction patterns of the respective films of the thin film multilayer body 16 of FIG. 3 by φ scan that rotates only a sample. FIG. 4A is the results of a φ scan performed on the (202) surface of the platinum film, FIG. 4B is the results of a φ scan performed on the (404) surface of the magnesia spinel film, and FIG. 4C is the results of a φ scan performed on the (404) surface of the silicon single crystal substrate. FIGS. 4A through 4C show that the platinum film, the magnesia spinel film, and the silicon single crystal substrate have respective four-fold axes of symmetry with the same angles. That is, it is shown that the thin film multilayer body 16 is epitaxially grown in a cube-on-cube manner on the silicon single crystal substrate 11.

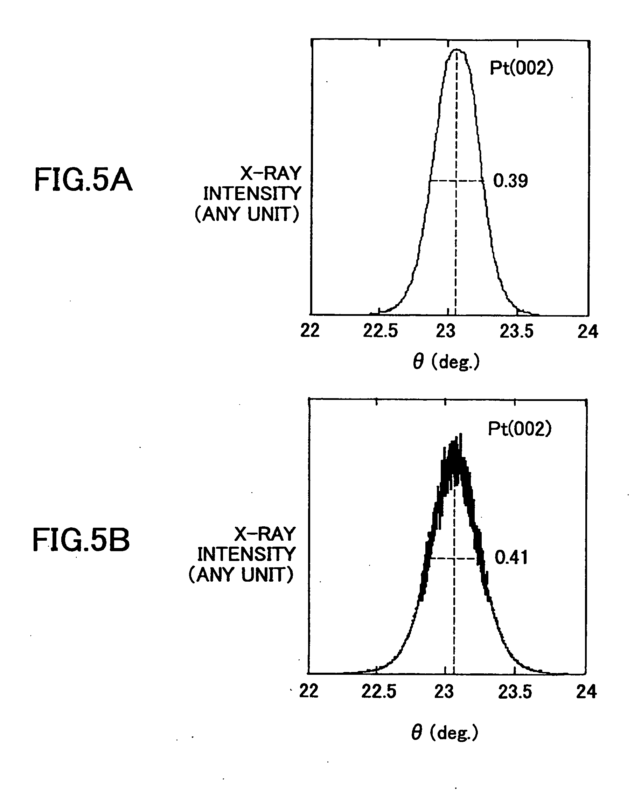

FIG. 5A is a diagram showing a rocking curve with respect to the (002) surface of the platinum film of the thin film multilayer body 16. On the other hand, FIG. 5B shows a rocking curve with respect to the (002) surface of a platinum film epitaxially grown on a MgO single crystal substrate that is not according to the present invention. Referring to FIG. 5A, the half-value width of the peak of the diffraction peak of the (002) surface of the platinum film of this mode of implementation is 0.39°, which is better than or equal to the half-value width 0.41 of the diffraction peak of the (002) surface of the platinum film that is not according to the present invention shown in FIG. 5B. This shows that the platinum film of the lower conductive layer 13 of this mode of implementation has good crystallinity.

The crystallinity of a platinum film is important in determining the crystallinity of an oxide layer of PZT or the like grown epitaxially on the platinum film, and it is preferable that the platinum film have as good crystallinity as possible. According to this mode of implementation, the platinum film is equivalent to a platinum film grown epitaxially on a MgO single crystal substrate. Accordingly, it is possible to form an oxide layer of good crystallinity.

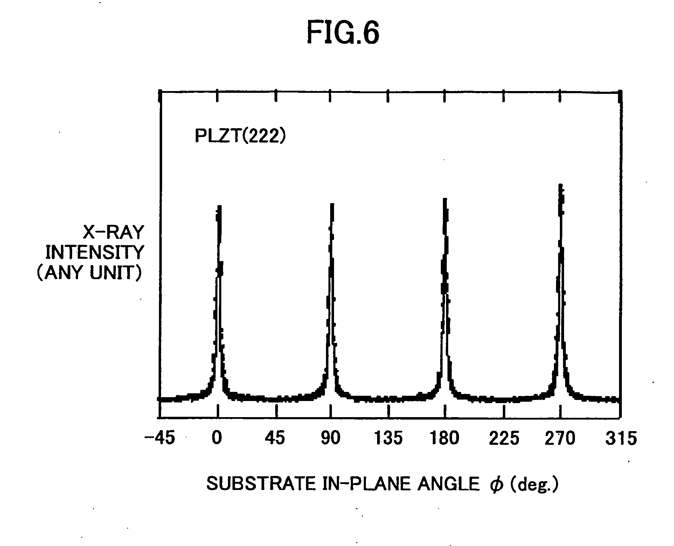

FIG. 6 is a diagram showing an X-ray diffraction pattern of the oxide layer of this mode of implementation by φ scan. This oxide layer is a PLZT film formed by applying a PLZT thin film formation agent (PLZT113/1.5/45/55, 15 wt.% in concentration) by CSD and crystallizing it. Here, PLZT113/1.5/45/55 indicates that the molarity ratio of Pb, La, Zr, and Ti is 113 : 1.5 : 45 : 55. Further, the φ scan was performed on the (222) surface of the PLZT film.

FIG. 6 shows that the PLZT film of the oxide layer has a four-fold axis of symmetry with the same angles as the single crystal substrate 11/the intermediate layer 12/the lower conductive layer 13 shown in FIGS. 4A through 4C. That is, it is shown that the oxide layer 14 is formed in a cube-on-cube manner on the lower conductive layer 13.

According to this mode of implementation, the intermediate layer 12 of a magnesia spinel film, the lower conductive layer 13, and the oxide layer 14 are epitaxially grown and formed sequentially on the silicon or GaAs single crystal substrate 11 as described above, and the lower conductive layer 13, which forms the base layer of the oxide layer 14, has as good crystallinity as a platinum film grown epitaxially on the conventional MgO single crystal substrate. Accordingly, a thin film multilayer body that has a conductive lower conductive layer and in which an oxide layer having good crystallinity and showing a piezoelectric or electrostrictive property is formable can be realized, the thin film multilayer body being formed of a single crystal substrate/an intermediate layer/the lower conductive layer.

Further, the oxide layer 14 is epitaxially grown and formed on the thin film multilayer body 16 formed on the silicon or GaAs single crystal substrate 11. Therefore, it is possible to realize an actuator that has an oxide layer having good crystallinity and showing a piezoelectric or electrostrictive property and can be larger in size and lower in cost.

### [First Embodiment]

A description is given below of an actuator according to an embodiment according to this mode of implementation. According to the actuator of this embodiment, magnesia spinel, a platinum film that is a lower conductive layer (electrode), a PZT film as an oxide layer, and an upper conductive layer are stacked sequentially on a silicon single crystal substrate.

First, a 2 in. silicon single crystal substrate whose principal plane is the (001) surface was cleaned, and thereafter, was soaked in a 9 wt.% dilute hydrofluoric acid so that a natural oxide film (SiOₓ) was removed from the surface of the silicon single crystal substrate.

Next, magnesia spinel of 100 nm in thickness is formed on the silicon single crystal substrate by CVD. Specifically, the silicon single crystal substrate was disposed in a CVD film formation chamber, and maintained at a substrate temperature of 900 °C. MgCl₂ was employed as a Mg material. It was heated to 500 °C in a Mg source chamber to be vaporized, and was sent to the film formation chamber using hydrogen gas as a carrier gas. Metal Al was employed as an Al material. It was heated to 550 °C in an Al source chamber to be vaporized, and was sent to the film formation chamber as AlCl₃ using hydrogen chloride gas and hydrogen gas as carrier gases. Further, carbon dioxide and hydrogen gas were introduced to be mixed with Mg and AlCl₃, and they were introduced into the film formation chamber. In the film formation chamber, the silicon single crystal substrate was heated to 900 °C, and a magnesia spinel film was formed at a film formation speed of 20 nm/min.

Next, a platinum film of 200 nm in thickness was formed on the magnesia spinel film by sputtering. Specifically, the pressure inside a sputtering device was set to 1 Pa (7.5 × 10⁻³ Torr), and while letting 30 sccm of argon gas and 1 sccm of oxygen gas flowing, the substrate was heated to 600 °C so as to cause its epitaxial growth.

Next, a PZT film was formed on the platinum film by CSD. Specifically, approximately 0.3 cm³ of a commercially available PZT thin film formation agent (PZT113/45/55, 15 wt.% in concentration) was dropped on the platinum film, and rotation was performed at 3000 rpm for 20 seconds. Here, PZT113/45/55 indicates that the molarity ratio of Pb, Zr, and Ti is 113 : 45 : 55. Next, the substrate on which PZT had been applied was heated at 350 °C for 1 minute on a hot plate so as to volatilize the solvent of the PZT thin film formation agent, and then was cooled to a room temperature. This process of forming the PZT film was performed four times in total.

Next, the PZT film is crystallized with a halogen lamp annealing device. Specifically, the substrate was disposed in the halogen lamp annealing device, and was heated at 650 °C for 10 minutes while letting oxygen gas flowing at 5 L/min., thereby crystallizing the PZT film. The thickness of the crystallized PZT film was set to 200 nm.

Next, an upper conductive layer of 150 nm in thickness is formed on the PZT film by sputtering. Specifically, the pattern of the upper conductive layer was disposed on the PZT film, and with the pressure inside a sputtering device being 1 Pa (7.5 × 10⁻³ Torr) and 30 sccm of argon gas flowing, a platinum film was formed.

Next, in order to remove damage caused to the PZT film at the time of the sputtering, the PZT film was annealed. Specifically, heating was performed at 600 °C for 1 hour in an electric furnace while letting oxygen gas flowing at 5 L/min. As a result, the actuator of this embodiment was formed.

### [Second Embodiment]

An actuator according to this embodiment is the same as in the first embodiment except that an iridium film is formed instead of the platinum film of the lower conductive layer and that PLZT is employed for the oxide layer of the first embodiment. In the following, a description of the same manufacturing processes as in the first embodiment is omitted.

According to the actuator of this embodiment, magnesia spinel, an iridium film that is a lower conductive layer, a PLZT film as an oxide layer, and an upper conductive layer are stacked sequentially on a silicon single crystal substrate.

The iridium film was formed to be 200 nm in thickness on the magnesia spinel film by sputtering. Specifically, the pressure inside a sputtering device was set to 1 Pa (7.5 × 10⁻³ Torr), and while letting 30 sccm of argon gas and 1 sccm of oxygen gas flowing, the substrate was heated to 600 °C so as to cause its epitaxial growth.

The PLZT film was formed on the iridium film by CSD. Specifically, approximately 0.3 cm³ of a commercially available PLZT thin film formation agent (PZT113/1.5/45/55, 15 wt.% in concentration) was dropped on the iridium film, and rotation was performed at 3000 rpm for 20 seconds. Next, the substrate on which PLZT had been applied was heated at 350 °C for 1 minute on a hot plate so as to volatilize the solvent of the PLZT thin film formation agent, and then was cooled to room temperature. This process of forming the PLZT film was performed four times in total.

Next, the PLZT film was crystallized with a halogen lamp annealing device. Specifically, the substrate was disposed in the halogen lamp annealing device, and was heated at 650 °C for 10 minutes while letting 5 sccm of oxygen gas flowing, thereby crystallizing the PZT film. The thickness of the crystallized PLZT film was set to 200 nm. Thereafter, the actuator of this embodiment was formed as in the first embodiment.

### (Second Mode of Implementation)

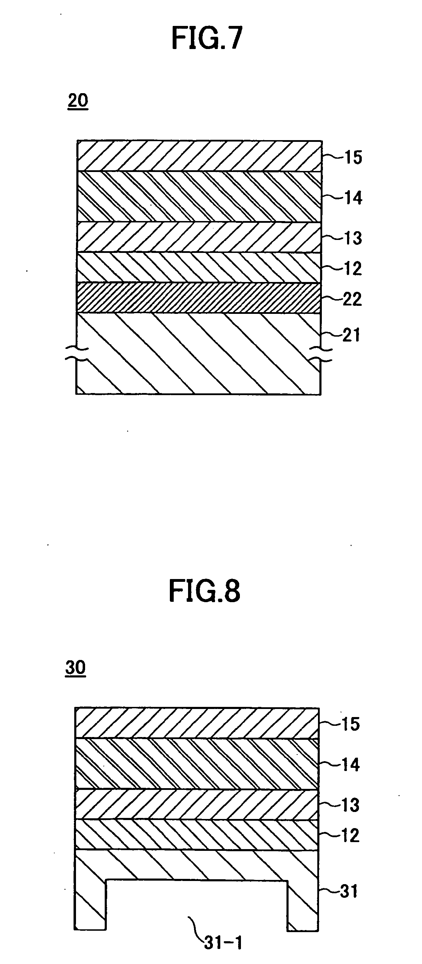

FIG. 7 is a sectional view of an actuator according to a mode of implementation of the present invention. In the drawing, the parts corresponding to those described above are referred to by the same numerals, and a description thereof is omitted.

Referring to FIG. 7, an actuator 20 of this embodiment is formed by sequentially stacking an amorphous layer 22, the intermediate layer 12, the lower conductive layer 13, the oxide layer 14, and the upper conductive layer 15 on a single crystal substrate 21. This mode of implementation is the same as the first mode of implementation except that the amorphous layer 22, formed as a result of partial thermal oxidation of the single crystal substrate 21, is further provided between the single crystal substrate 21 and the intermediate layer 12.

As shown in step S105 of FIG. 2, the amorphous layer 22 is formed by performing heat treatment after forming the magnesia spinel intermediate layer 12 on the single crystal substrate 21. Specifically, when the single crystal substrate 21 is silicon, heat treatment is performed at 1000 °C to 1100 °C for 30 minutes to 3 hours while letting vapor flowing at 10 L/min. by bubbling using oxygen gas as a carrier gas under atmospheric pressure. This heat treatment causes oxygen to be diffused from the magnesia spinel intermediate layer 12 into the single crystal substrate 21, so that the amorphous layer 22 due to thermal oxidation is formed on the surface of the single crystal substrate 21. An amorphous layer unbinds a single crystal substrate and magnesia spinel, so that the crystallinity of magnesia spinel can be further improved because of its rearrangement.

Thereafter, the layers forming the actuator 20 of this mode of implementation are formed as in the first mode of implementation.

According to this mode of implementation, the crystallinity of the lower conductive layer 13 and the oxide layer 14 formed on the magnesia spinel film is further improved by further increasing the crystallinity of the magnesia spinel film. As a result, it is possible to realize an actuator of higher performance having an oxide layer having a good piezoelectric or electrostrictive property.

### [Third Embodiment]

An actuator according to this embodiment is the case of providing a thermal oxide layer between the silicon single crystal substrate and the intermediate layer of the first embodiment, and is the same as in the first embodiment except that the thermal oxide layer is provided and that the oxide layer is formed by PLD.

The actuator of this embodiment is formed by sequentially stacking a thermal oxide layer, a magnesia spinel film, an iridium film, a PZT film, and a platinum film on a silicon substrate.

The thermal oxide layer is formed in an oxygen atmosphere with a furnace after forming the magnesia spinel on the silicon substrate. Specifically, heating is performed at 1050 °C for two hours while letting vapor flowing to the furnace at 10 L/min. by bubbling using oxygen gas as a carrier gas. The thermal oxide layer of 150 nm in thickness was formed.

Next, the PZT film was formed by PLD. Specifically, using a target of PNN-PT-PZ50/35/15 including 30 mol% excessive lead oxide, the substrate was heated to 600 °C at 13.3 Pa (0.1 Torr) inside a chamber while letting 6 sccm of oxygen gas flowing, and the laser light of an Nd:YAG laser (355 nm wavelength) was emitted to the target at a repetition rate of 10 Hz, thereby forming the PZT film of 350 nm in thickness. Thereafter, the actuator of the third embodiment was formed as in the first embodiment.

### (Third Mode of Implementation)

FIG. 8 is a sectional view of an actuator according to this mode of implementation. In the drawing, the parts corresponding to those described above are referred to by the same numerals, and a description thereof is omitted.

Referring to FIG. 8, an actuator 30 of this mode of implementation is formed by sequentially stacking the intermediate layer 12, the lower conductive layer 13, the oxide layer 14, and the upper conductive layer 15 on the single crystal substrate 31, and has a diaphragm structure with a recess 31-1 provided in the single crystal substrate 31. The actuator 30 of this mode of implementation is the same as the actuator 10 of the first mode of implementation except that the recess is provided on the bottom side of the single crystal substrate.

The diaphragm structure of the single crystal substrate 31 is provided after the upper conductive layer 15 is formed. In the diaphragm structure, while the thickness of the single crystal substrate 31 is 500 µm, the depth of the recess 31-1 is approximately 470 µm so that the thickness of the thinned part is approximately 30 µm. Further, etching may be performed until the lower conductive layer 13 is exposed. The displacement efficiency of the actuator 30 can be improved by providing flexibility by reducing the thickness of the single crystal substrate 31.

The diaphragm structure is formed by forming resist on the bottom side of the silicon substrate, patterning the resist by photolithography, and performing etching by a soaking in a KOH solution of 45 wt.% in concentration. A protection film such as resist is formed on the surface of the upper conductive layer so as to prevent it from being etched.

According the actuators of the first and second modes of implementation, one side of the oxide layer showing a piezoelectric or electrostrictive property is fixed to the single crystal substrate. Accordingly, when the oxide layer 14 is displaced, the single crystal substrate 31 generates stress in a direction to prevent the displacement. For instance, in the case of compressive deformation in an in-film plane direction of the oxide layer, the single crystal substrate 31 generates stress in a stretching direction. This stress can be reduced by providing flexibility by reducing the film thickness of the single crystal substrate 31. That is, the displacement efficiency of the actuator can be improved by providing a diaphragm structure to the single crystal substrate 31.

In this mode of implementation, a description is given of the case of providing the single recess 31-1. Alternatively, multiple minute recesses of the same depth may be provided. As in this mode of implementation, flexibility may be provided to the single crystal substrate below the oxide layer so that the displacement efficiency of the actuator can be improved.

### (Fourth Mode of Implementation)

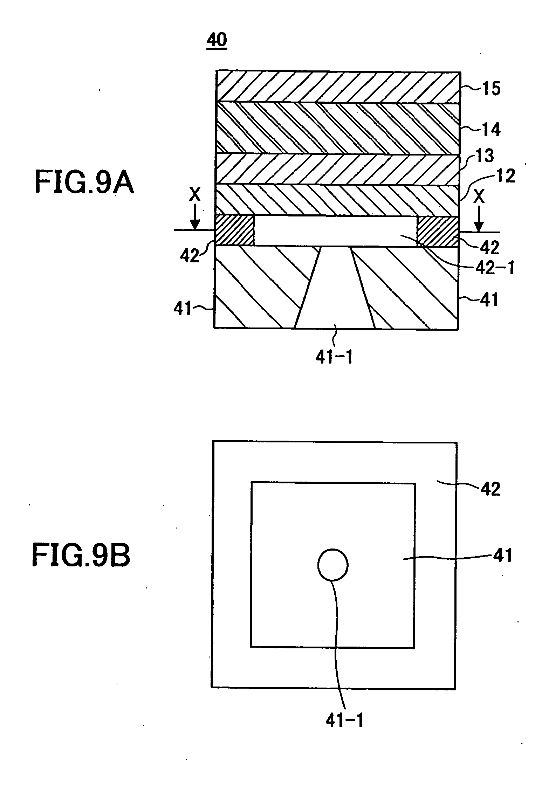

FIG. 9A is a sectional view of an actuator according to this mode of implementation, and FIG. 9B is a view on arrow X-X shown in FIG. 9A. In the drawings, the parts corresponding to those described above are referred to by the same numerals, and a description thereof is omitted.

Referring to FIGS. 9A and 9B, an actuator 40 according to this mode of implementation is formed by sequentially stacking an amorphous layer 42, the intermediate layer 12, the lower conductive layer 13, the oxide layer 14, and the upper conductive layer 15 on a single crystal substrate 41, and is structured to have a frame body-like opening part provided in the amorphous layer 42. This mode of implementation is the same as the actuator of the above-described second mode of implementation except that a groove is provided in the single crystal substrate 41 and that the opening part is provided in the amorphous layer 42.

A groove 41-1 is provided through the single crystal substrate 41 from the bottom side thereof to the amorphous layer 42 in order to provide the opening part in the amorphous layer 42. This groove 41-1 is provided in order to inject an etching agent for providing the opening part 42-1 in the amorphous layer 42.

The amorphous layer 42 is chemically ground outward from around the center of the amorphous layer by etching so as to leave only the vicinity of the edge of the amorphous layer 42. Specifically, this structure is formed as follows.

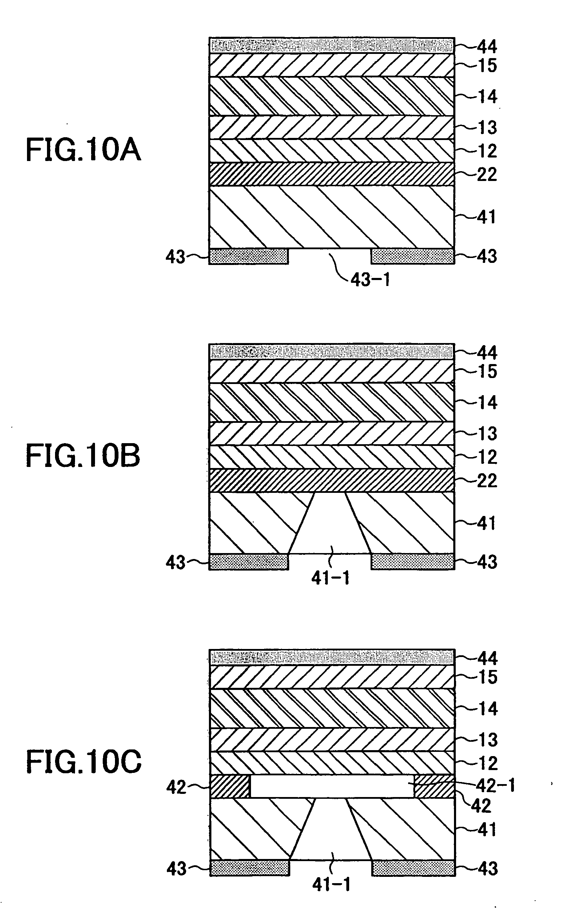

FIGS. 10A through 10C are diagrams showing a manufacturing process of the actuator 40 of this mode of implementation.

In the process of FIG. 10A, first, as in the actuator of the second mode of implementation, after the formation of up to the upper conductive layer 15, resist 43 is formed on the bottom side of the single crystal substrate 41, and is patterned by photolithography, so that an opening part 43-1 is formed in the center part. A protection film 44 such as resist is formed on the surface of the upper conductive layer 15 so as to prevent it from being etched.

Next, in the process of FIG. 10B, anisotropic etching is performed on the single crystal substrate 41 by its being soaked in a KOH saturated solution of 80 °C for approximately 3 hours so that the amorphous layer 42 is exposed.

Next, in the process of FIG. 10C, the amorphous layer 42 is etched by a soaking in a 10 wt.% dilute hydrofluoric acid for approximately 5 seconds so that the opening part is formed in the amorphous layer 42. The etching range of the amorphous layer 42 may be set by a hydrofluoric acid concentration and the soak period. Further, the resist 43 and the protection film 44 are removed, so that the frame body-like structure shown in FIGS. 9A and 9B is formed.

The actuator 40 of this mode of implementation is reduced in film thickness by having only the intermediate layer 12 and the lower conductive layer 13 on one side of the oxide layer 14 so as to have more flexibility. Further, a space for deflection at the time of the displacement of the oxide layer 14 is provided so as to allow the actuator 40 to be displaced in a wider range. As a result, the displacement efficiency of the actuator 40 can be further improved.

A description is given above of preferred embodiments of the present invention. However, the present invention is not limited to the specific modes of implementation, and variations and modifications may be made within the scope of the present invention recited in CLAIMS.

In the above-described modes of implementation and embodiments, actuators having one set of lower and upper conductive layers and an oxide layer showing a piezoelectric or electrostrictive property sandwiched therebetween are shown. Alternatively, multiple actuators may be bonded in layers. The multilayer longitudinal effect makes it possible to increase displacement greatly with approximately the same applied voltage as in the case of a single actuator.

Further, the present invention is applicable to electronic devices such as a capacitor element and an FeRAM (Ferroelectric RAM) with the same configurations as those of the actuators of the above-described first and second modes of implementation. The oxide layer according to the present invention has a high dielectric property. Accordingly, it is possible to reduce the lower and upper conductive layers in area. As a result, it is possible to form a capacitor element that can be reduced in size.

Further, by forming a comb-shaped electrode by patterning the upper conductive layer in the configurations of the actuators of the above-described first and second modes of implementation, they can be employed as surface acoustic wave devices such as surface acoustic wave filters (SAW filters). The oxide layer of the present invention has a good piezoelectric or electrostrictive property. Accordingly, it is possible to realize a low-loss surface acoustic wave filter that can be reduced in size.

### INDUSTRIAL APPLICABILITY

A conductive layer is formed by epitaxial growth on a silicon or gallium arsenide single crystal substrate through an intermediate layer. Accordingly, it is possible to realize a thin film multilayer body that has a conductive layer and in which an oxide layer having good crystallinity and showing a piezoelectric or electrostrictive property is formable.

Further, the intermediate layer, the lower conductive layer, and an oxide layer stacked on the silicon or gallium arsenide single crystal substrate are formed by epitaxial growth. Accordingly, it is possible to realize a high-performance, low-price actuator having an oxide layer having good crystallinity and a good piezoelectric or electrostrictive property.

## Claims

1. A thin film multilayer body, comprising:
a single crystal substrate of silicon or gallium arsenide;
an intermediate layer of magnesia spinel formed on the single crystal substrate by epitaxial growth; and
a lower conductive layer formed on the intermediate layer by epitaxial growth,
wherein an oxide layer is to be epitaxially grown on the conductive layer, the oxide layer having a crystalline structure having a simple perovskite lattice, **characterised in that** the lower conductive layer is formed of iridium.

2. The thin film multilayer body as claimed in claim 1, wherein an amorphous layer is further formed between the single crystal substrate and the intermediate layer.

3. A thin film multilayer body, comprising:
a single crystal substrate of silicon or gallium arsenide;
an intermediate layer of magnesia spinel formed on the single crystal substrate by epitaxial growth;
a lower conductive layer formed on the intermediate layer by epitaxial growth; and
an oxide layer formed on the conductive layer by epitaxial growth, the oxide layer having a crystalline structure having a simple perovskite lattice, **characterised in that** the lower conductive layer is formed of iridium.

4. The thin film multilayer body as claimed in claim 3, wherein an amorphous layer is further formed between the single crystal substrate and the intermediate layer.

5. The thin film multilayer body as claimed in any of claims 1 to 4, wherein the crystalline structure having the perovskite lattice is one of a perovskite structure, a bismuth layer structure, and a tungsten bronze structure.

6. The thin film multilayer body as claimed in any of claims 1 to 4, wherein the oxide layer is formed of one selected from a group of Pb(Zr₁₋ₓTiₓ)O₃ (0 ≤ x ≤ 1) , (Pb_{1-y}La_{y})(Zr₁₋ₓTiₓ)O₃ (0 ≤ x, y ≤ 1), Pb(B'_{1/3}B''_{2/3})ₓTi_{y}Zr_{1-x-y}O₃ (0 ≤ x, y ≤ 1, B' is bivalent metal, B" is pentavalent metal), and Pb(B'_{1/2}B''_{1/2})ₓTi_{y}Zr_{1-x-y}O₃ (0 ≤ X, y ≤ 1; B'is trivalent metal and B" is pentavalent metal, or B' is bivalent metal and B" is hexavalent metal).

7. An electronic device, comprising:
the thin film multilayer body as claimed in claim 3 or 4.

8. An actuator, comprising:
a thin film multilayer body as defined in claim 3; and
an upper conductive layer formed on the oxide layer,
wherein the oxide layer shows a piezoelectric or electrostrictive property.

9. The actuator as claimed in claim 8, wherein an amorphous layer is further formed between the single crystal substrate and the intermediate layer.

10. The actuator as claimed in claim 9, wherein an opening part is provided in the amorphous layer.

11. The actuator as claimed in any of claims 8 to 10, wherein a recess is provided on a bottom side of the single crystal substrate.

12. The actuator as claimed in any of claims 8 to 10, wherein the crystalline structure having the perovskite lattice is one of a perovskite structure, a bismuth layer structure, and a tungsten bronze structure.

13. The actuator as claimed in any of claims 8 to 10, wherein the oxide layer is formed of one selected from a group of Pb(Zr₁₋ₓTiₓ)O₃ (0 ≤ x ≤ 1), (Pb_{1-y}La_{y}) (Zr₁₋ₓTiₓ)O₃ (0 ≤ x, y ≤ 1), Pb(B'_{1/3}B''_{2/3})ₓTi_{y}Zr_{1-x-y}O₃ (0 ≤ x, y ≤ 1, B' is bivalent metal, B'' is pentavalent metal), and Pb(B'_{1/2}B''_{1/2})ₓTi_{y}Zr_{1-x-y}O₃ (0 ≤ x, y ≤ 1; B' is trivalent metal and B'' is pentavalent metal, or B' is bivalent metal and B'' is hexavalent metal).

14. The actuator as claimed in any of claims 8 to 10, wherein a conductive oxide layer having conductivity is provided in at least one of a space between the lower conductive layer and the oxide layer and a space between the oxide layer and the upper conductive layer.

15. The actuator as claimed in claim 14, wherein the conductive oxide layer is formed of material including one selected from a group of SrRuO₃, CaRuO₃, LaNiO₃, LaₓSr₁₋ₓCoO₃ (0 ≤ x ≤ 1), and LaₓSr₁₋ₓMnO₃ (0 ≤ x ≤ 1) as a principal component.

16. The actuator as claimed in any of claims 8 to 10, wherein a semiconductive oxide layer is provided in at least one of a space between the lower conductive layer and the oxide layer and a space between the oxide layer and the upper conductive layer.

17. The actuator as claimed in claim 16, wherein the semiconductive oxide layer is formed of material including SrTiO₃ doped with at least one of Nb and La as a principal component.

18. A method of manufacturing an actuator in which epitaxial films are stacked, comprising:
an intermediate layer formation process of forming an intermediate layer of magnesia spinel on a single crystal substrate of silicon or gallium arsenide by epitaxial growth;
a lower conductive layer formation process of forming a lower conductive layer of iridium on the intermediate layer by epitaxial growth;
an oxide layer formation process of forming an oxide layer of a crystalline structure having a simple perovskite lattice on the lower conductive layer by epitaxial growth; and
an upper conductive layer formation process of forming an upper conductive layer on the oxide layer.

19. The method of manufacturing the actuator as claimed in claim 18, further comprising a process of forming an amorphous layer between the single crystal substrate and the intermediate layer by heat treatment between the intermediate layer formation process and the conductive layer formation process.

20. The method of manufacturing the actuator as claimed in claim 19, further comprising a process of forming a groove that exposes the amorphous layer from a bottom side of the single crystal substrate and chemically etching part of the amorphous layer through the groove after the upper conductive layer formation process.

21. The method of manufacturing the actuator as claimed in claim 19 or 20, further comprising a process of forming a recess on a bottom side of the single crystal substrate after the upper conductive layer formation process.

## Patentansprüche

1. Ein Dünnfilm-Mehrschichtkörper, umfassend:
einen Einkristallträger aus Silizium oder Galliumarsenid;
eine Zwischenschicht aus Magnesiumspinell, die auf dem Einkristallträger durch epitaxiales Wachstum ausgebildet ist; und
eine untere leitende Schicht, die auf der Zwischenschicht durch epitaxiales Wachstum ausgebildet ist,
wobei eine Oxidschicht auf der leitenden Schicht epitaxial zu entwickeln ist, wobei die Oxidschicht einen kristallinen Aufbau mit einem einfachen Perowskit-Gitter hat, **gekennzeichnet dadurch, dass** die untere leitende Schicht aus Iridium ausgebildet ist.

2. Der Dünnfilm-Mehrschichtkörper, wie in Anspruch 1 beansprucht, wobei ferner eine amorphe Schicht zwischen dem Einkristallträger und der Zwischenschicht ausgebildet ist.

3. Ein Dünnfilm-Mehrschichtkörper, umfassend:
einen Einkristallträger aus Silizium oder Galliumarsenid;
eine Zwischenschicht aus Magnesiumspinell, die auf dem Einkristallträger durch epitaxiales Wachstum ausgebildet ist;
eine untere leitende Schicht, die auf der Zwischenschicht durch epitaxiales Wachstum ausgebildet ist, und
eine Oxidschicht, die auf der leitenden Schicht durch epitaxiales Wachstum ausgebildet ist, wobei die Oxidschicht einen kristallinen Aufbau mit einem einfachen Perowskit-Gitter hat, **gekennzeichnet dadurch, dass** die untere leitende Schicht aus Iridium ausgebildet ist.

4. Der Dünnfilm-Mehrschichtkörper, wie in Anspruch 3 beansprucht, wobei ferner eine amorphe Schicht zwischen dem Einkristallträger und der Zwischenschicht ausgebildet ist.

5. Der Dünnfilm-Mehrschichtkörper, wie in beliebigen von Ansprüchen 1 bis 4 beansprucht, wobei der kristalline Aufbau mit dem Perowskit-Gitter einer von einem Perowskit-Aufbau, einem Wismut-Schichtaufbau und einem Tungsten-Bronze-Aufbau ist.

6. Der Dünnfilm-Mehrschichtkörper, wie in beliebigen von Ansprüchen 1 bis 4 beansprucht, wobei die Oxidschicht aus einer ausgebildet wird, die ausgewählt wird aus einer Gruppe von Pb(Zr₁₋ₓTiₓ)O₃ (0 ≤ x ≤ 1), (Pb_{1-y}La_{y})(Zr₁₋ₓTiₓ)O₃ (0 ≤ x, y ≤ 1), Pb(B'_{1/3}B''_{2/3})ₓTi_{y}Zr_{1-x-y}O₃ (0 ≤ x, y ≤ 1, B' zweiwertiges Metall ist, B'' fünfwertiges Metall ist), und Pb(B'_{1/2}B"_{1/2})ₓTi_{y}Zr_{1-x-y}O₃ (0 ≤ x, y ≤ 1; B' dreiwertiges Metall ist und B'' fünfwertiges Metall ist, oder B' zweiwertiges Metall ist und B'' sechswertiges Metall ist).

7. Eine elektronische Einrichtung, umfassend:
den Dünnfilm-Mehrschichtkörper, die in Anspruch 3 oder 4 beansprucht.

8. Ein Aktuator, umfassend:
einen Dünnfilm-Mehrschichtkörper, wie in Anspruch 3 definiert; und
eine obere leitende Schicht, die auf der Oxidschicht ausgebildet ist,
wobei die Oxidschicht eine piezoelektrische oder elektrostriktive Eigenschaft zeigt.

9. Der Aktuator, wie in Anspruch 8 beansprucht, wobei ferner eine amorphe Schicht zwischen dem Einkristallträger und der Zwischenschicht ausgebildet ist.

10. Der Aktuator, wie in Anspruch 9 beansprucht, wobei ein Öffnungsteil in der amorphen Schicht vorgesehen ist.

11. Der Aktuator, wie in beliebigen von Ansprüchen 8 bis 10 beansprucht, wobei eine Ausnehmung auf einer Bodenseite des Einkristallträgers vorgesehen ist.

12. Der Aktuator, wie in beliebigen von Ansprüchen 8 bis 10 beansprucht, wobei der kristalline Aufbau mit dem Perowskit-Gitter einer von einem Perowskit-Aufbau, einem Wismut-Schichtaufbau und einem Tungsten-Bronze-Aufbau ist.

13. Der Aktuator, wie in beliebigen von Ansprüchen 8 bis 10 beansprucht, wobei die Oxidschicht aus einer ausgebildet ist, die ausgewählt ist aus einer Gruppe von Pb(Zr₁₋ₓTiₓ)O₃ (0 ≤ x ≤ 1), (Pb_{1-y}La_{y}) (Zr₁₋ₓTiₓ)O₃ (0 ≤ x, y ≤ 1), Pb(B'_{1/3}B''_{2/3})ₓTi_{y}Zr_{1-x-y}O₃ (0 ≤ x, y ≤ 1, B' zweiwertiges Metall ist, B'' fünfwertiges Metall ist), und Pb(B'_{1/2}B''_{1/2})ₓTi_{y}Zr_{1-x-y}O₃ (0 ≤ x, y ≤ 1, B' dreiwertiges Metall ist und B'' fünfwertiges Metall ist, oder B' zweiwertiges Metall ist und B'' sechswertiges Metall ist).

14. Der Aktuator, wie in beliebigen von Ansprüchen 8 bis 10 beansprucht, wobei eine leitende Oxidschicht mit einer Leitfähigkeit in mindestens einem von einem Raum zwischen der unteren leitenden Schicht und der Oxidschicht und einem Raum zwischen der Oxidschicht und der oberen leitenden Schicht vorgesehen ist.

15. Der Aktuator, wie in Anspruch 14 beansprucht, wobei die leitende Oxidschicht aus einem Material ausgebildet ist, das ein ausgewähltes aus einer Gruppe von SrRuO₃, CaRuO₃, LaNiO₃, LaₓSr₁₋ₓCoO₃ (0 ≤ x ≤ 1), und LaₓSr₁₋ₓMnO₃ (0 ≤ x ≤ 1) als eine Hauptkomponente enthält.

16. Der Aktuator, wie in beliebigen von Ansprüchen 8 bis 10 beansprucht, wobei eine halbleitende Oxidschicht in mindestens einem von einem Raum zwischen der unteren leitenden Schicht und der Oxidschicht und einem Raum zwischen der Oxidschicht und der oberen leitenden Schicht vorgesehen ist.

17. Der Aktuator, wie in Anspruch 16 beansprucht, wobei die halbleitende Oxidschicht aus einem Material ausgebildet ist, das SrTiO₃, das mit mindestens einem von Nb und La dotiert ist, als eine Hauptkomponente enthält.

18. Ein Verfahren zum Herstellen eines Aktuators, in dem epitaxiale Filme geschichtet sind, umfassend:
einen Zwischenschicht-Bildungsprozess zum Bilden einer Zwischenschicht aus Magnesiumspinell auf einem Einkristallträger aus Silizium oder Galliumarsenid durch epitaxiales Wachstum;
einen Bildungsprozess der unteren leitenden Schicht zum Bilden einer unteren leitenden Schicht aus Iridium auf der Zwischenschicht durch epitaxiales Wachstum;
einen Oxidschicht-Bildungsprozess zum Bilden einer Oxidschicht eines kristallinen Aufbaus mit einem einfachen Perowskit-Gitter auf der unteren leitenden Schicht durch epitaxiales Wachstum; und
einen Bildungsprozess einer oberen leitenden Schicht zum Bilden einer oberen leitenden Schicht auf der Oxidschicht.

19. Das Verfahren zum Herstellen des Aktuators, wie in Anspruch 18 beansprucht, ferner umfassend einen Prozess zum Bilden einer amorphen Schicht zwischen dem Einkristallträger und der Zwischenschicht durch Wärmebehandlung zwischen dem Zwischenschicht-Bildungsprozess und dem Bildungsprozess der leitenden Schicht.

20. Das Verfahren zum Herstellen des Aktuators, wie in Anspruch 19 beansprucht, ferner umfassend einen Prozess zum Bilden einer Nut, was die amorphe Schicht von einer Bodenseite des Einkristallträgers freilegt, und chemischen Ätzen eines Teils der amorphen Schicht durch die Nut nach dem Bildungsprozess der oberen leitenden Schicht.

21. Das Verfahren zum Herstellen des Aktuators, wie in Ansprüchen 19 oder 20 beansprucht, ferner umfassend einen Prozess zum Bilden einer Ausnehmung auf einer Bodenseite des Einkristallträgers nach dem Bildungsprozess der oberen leitenden Schicht.

## Revendications

1. Corps multicouche à film mince, comprenant :
un substrat monocristal d'arséniure de silicium ou de gallium ;
une couche intermédiaire de spinelle de magnésie formée sur le substrat monocristal par croissance épitaxique, et
une couche inférieure conductrice formée sur la couche intermédiaire par croissance épitaxique,
où une couche d'oxyde est mise à croître par épitaxie sur la couche conductrice, la couche d'oxyde ayant une structure cristalline ayant un réseau perovskite simple, **caractérisé en ce que** la couche inférieure conductrice est formée d'iridium.

2. Corps multicouche à film mince selon la revendication 1, dans lequel une couche amorphe est encore formée entre le substrat monocristal et la couche intermédiaire.

3. Corps multicouche à film mince, comprenant :
un substrat monocristal d'arséniure de silicium ou de gallium ;
une couche intermédiaire de spinelle de magnésie formée sur le substrat monocristal par croissance épitaxique ;
une couche inférieure conductrice formée sur la couche intermédiaire par croissance épitaxique, et
une couche d'oxyde formée sur la couche conductrice par croissance épitaxique, la couche d'oxyde ayant une structure cristalline ayant un réseau perovskite simple, **caractérisé en ce que** la couche inférieure conductrice est formée d'iridium.

4. Corps multicouche à film mince selon la revendication 3, dans lequel une couche amorphe est encore formée entre le substrat monocristal et la couche intermédiaire.

5. Corps multicouche à film mince selon l'une quelconque des revendications 1 à 4, dans lequel la structure cristalline ayant le réseau perovskite est choisie parmi une structure perovskite, une structure de couche de bismuth, et une structure de bronze de tungstène.

6. Corps multicouche à film mince selon l'une quelconque des revendications 1 à 4, dans lequel la couche d'oxyde est formée de l'un choisi parmi un groupe de Pb(Zr₁₋ₓTiₓ)O₃ (0 ≤ x ≤ 1), (Pb_{1-y}La_{y})(Zr₁₋ₓTiₓ)O₃ (0 ≤ x, y ≤ 1), Pb(B'_{1/3}B"_{2/3})ₓTi_{y}Zr_{1-x-y})O₃ (0 ≤ x, y ≤ 1, B' est un métal bivalent, B" est un métal pentavalent), et Pb(B'_{1/2}B"_{1/2})ₓTi_{y}Zr_{1-x-y})O₃ (0 ≤ x, y ≤ 1, B' est un métal trivalent, B" est un métal hexavalent).

7. Dispositif électronique, comprenant :
le corps multicouche à film fin selon la revendication 3 ou 4.

8. Actuateur, comprenant
un corps multicouche à film fin tel que défini à la revendication 3 ;
une couche conductrice supérieure formée sur la couche d'oxyde,
où la couche d'oxyde montre une propriété piézoélectrique ou électrostrictive.

9. Actuateur selon la revendication 8, dans lequel une couche amorphe est encore formée entre le substrat monocristal et la couche intermédiaire.

10. Actuateur selon la revendication 9, dans lequel une partie d'ouverture est disposée dans la couche amorphe.

11. Actuateur selon l'une quelconque des revendications 8 à 10, dans lequel un retrait est disposé sur une face inférieure du substrat monocristal.

12. Actuateur selon l'une quelconque des revendications 8 à 10, dans lequel la structure monocristal ayant le réseau perovskite est choisie parmi une structure perovskite, une structure de couche de bismuth, et une structure de bronze de tungstène.

13. Actuateur selon l'une quelconque des revendications 8 à 10, dans lequel la couche d'oxyde est formée de l'un choisi parmi un groupe de Pb(Zr₁₋ₓTiₓ)O₃ (0 ≤ x ≤ 1), (Pb_{1-y}La_{y})(Zr₁₋ₓTiₓ)O₃ (0 ≤ x, y ≤ 1), Pb(B'_{1/3}B"_{2/3})ₓTiyZr_{1-x-y})O₃ (0 ≤ x, y ≤ 1, B' est un métal bivalent, B" est un métal pentavalent), et Pb(B'_{1/2}B"_{1/2})ₓTi_{y}Zr_{1-x-y})O₃ (0 ≤ x, y ≤ 1, B' est un métal trivalent, B" est un métal hexavalent).

14. Actuateur selon l'une quelconque des revendications 8 à 10, dans lequel une couche d'oxyde conductrice ayant une conductibilité est disposée dans au moins un espace entre la couche conductrice inférieure et la couche d'oxyde et un espace entre la couche d'oxyde et la couche conductrice supérieure.

15. Actuateur selon la revendication 14, dans lequel la couche d'oxyde conductrice est formée d'un matériau comprenant l'un choisi parmi un groupe de SrRuO₃, CaRuO₃, LaNiO₃, LaₓSr₁₋ₓCoO₃ (0 ≤ x ≤ 1) et LaₓSr₁₋ₓMnO₃ (0 ≤ x ≤ 1) comme composant principal.

16. Actuateur selon l'une quelconque des revendications 8 à 10, dans lequel une couche d'oxyde semi-conductrice est disposée dans au moins un espace entre la couche conductrice inférieure et la couche d'oxyde et un espace entre la couche d'oxyde et la couche conductrice supérieure.

17. Actuateur selon la revendication 16, dans lequel la couche d'oxyde semi-conductrice est formée d'un matériau comprenant SrTiO₃, dopé avec au moins un parmi le Nb et le La comme composant principal.

18. Procédé de préparation d'un actuateur, dans lequel des films épitaxiques sont empilés, comprenant :
un procédé de formation d'une couche intermédiaire pour la formation d'une couche intermédiaire de spinelle de magnésie sur un substrat monocristal d'arséniure de silicium ou de gallium par croissance épitaxique ;
un procédé de formation d'une couche conductrice inférieure pour la formation d'une couche conductrice inférieure d'iridium sur la couche intermédiaire par croissance épitaxique ;
un procédé de formation d'une couche d'oxyde pour la formation d'une couche d'oxyde d'une structure cristalline ayant un réseau perovskite simple sur la couche conductrice inférieure par croissance épitaxique, et
un procédé de formation d'une couche conductrice supérieure pour la formation d'une couche conductrice supérieure sur la couche d'oxyde.

19. Procédé de préparation de l'actuateur selon la revendication 18, comprenant en outre un procédé de formation d'une couche amorphe entre le substrat monocristal et la couche intermédiaire par traitement thermique entre le procédé de formation de la couche intermédiaire et le procédé de formation de la couche conductrice.

20. Procédé de préparation de l'actuateur selon la revendication 19, comprenant en outre un procédé de formation d'une rainure qui expose la couche amorphe depuis une face inférieure du substrat monocristal et la corrosion chimique d'une partie de la couche amorphe par la rainure après le procédé de formation de la couche conductrice supérieure.

21. Procédé de préparation de l'actuateur selon la revendication 19 ou 20, comprenant en outre un procédé de formation d'un retrait sur une face inférieure du substrat monocristal après le procédé de formation de la couche conductrice supérieure.
